Europäisches Patentamt

European Patent Office

Office européen des brevets

(11) Veröffentlichungsnummer: **0 271 704 B1**

# EUROPÄISCHE PATENTSCHRIFT

(45) Veröffentlichungstag der Patentschrift: **18.03.92**

(21) Anmeldenummer: **87116447.1**

(22) Anmeldetag: **06.11.87**

(51) Int. Cl.⁵: **F25B 21/02**, H01L 35/30, //B60H1/32

54 **Thermoelektrische Kühlvorrichtung.**

(30) Priorität: **14.11.86 DE 3639089**

(43) Veröffentlichungstag der Anmeldung:
**22.06.88 Patentblatt 88/25**

(45) Bekanntmachung des Hinweises auf die
Patenterteilung:
**18.03.92 Patentblatt 92/12**

(84) Benannte Vertragsstaaten:
**AT BE CH DE ES FR GB GR IT LI NL SE**

(56) Entgegenhaltungen:
**DE-B- 1 079 659     DE-B- 1 135 016**
**DE-B- 1 284 566     FR-A- 1 355 802**
**FR-A- 1 409 429     US-A- 2 932 953**
**US-A- 2 947 150     US-A- 3 040 539**
**US-A- 3 212 275     US-A- 3 216 204**
**US-A- 3 240 261     US-A- 3 324 667**
**US-A- 3 402 561     US-A- 3 769 805**

**PATENT ABSTRACTS OF JAPAN, Band 7, Nr.
128 (M-220)[1273], 3. Juni 1983, Seite 149 M
220; & JP-A-58 47 619 (FUJI JUKOGYO K.K.)
19-03-1983**

(73) Patentinhaber: **unitechnica Mobilkälte GmbH
Robert-Bosch-Strasse 18
W-7141 Möglingen(DE)**

(72) Erfinder: **Ilchman, Udo, Dipl.-Ing. (FH)
Heinsestrasse 5b
W-8750 Aschaffenburg(DE)**

(74) Vertreter: **Schwan, Gerhard, Dipl.-Ing.
Elfenstrasse 32
W-8000 München 83(DE)**

**Beschreibung**

Die Erfindung betrifft eine thermoelektrische Kühlvorrichtung, insbesondere für Kühlboxen in Kraftfahrzeugen, mit einem aus mindestens einem Peltierblock bestehenden thermoelektrischen Kälteerzeuger, dessen warme Seite mit einem ersten Wärmetauscher wärmeleitend verbunden ist und dessen kalte Seite mit einem dem Kühlen eines Kühlraumes dienenden zweiten Wärmetauscher in wärmeleitender Verbindung steht, wober der erste Wärmetauscher von einem flüssigen Kühlmittel durchströmt ist, das in einem Flüssigkeitskreislauf zwangsumgewälzt wird, der mit einem dritten Wärmetauscher in Form eines Luft/Flüssigkeits-Wärmetauschers zum Kühlen des flüssigen Kühlmittels versehen ist.

Eine Kühlvorrichtung dieser Art ist aus der DE-B-1 135 016 bekannt. Dabei besteht der zweite Wärmetauscher aus wärmeaufnehmenden Teilen, die in den Kühlraum hineinragen und die mit ihrem vom Kühlraum abgewendeten Ende an dem Peltierblock anliegen.

Es ist ferner eine thermoelektrische Kühlvorrichtung mit einem Peltierblock bekannt (US-A-2 932 953), dessen kalte Seite mit einem Rippenwärmetauscher in wärmeleitender Verbindung steht. Dieser Rippenwärmetauscher sitzt in einem Strömungskanal, durch den hindurch Luft zwangsumgewälzt werden kann.

Desweiteren ist es bekannt (FR-A-1 355 802), bei einem Rippenwärmetauscher Stege aus Aluminium-Feinblech vorzusehen, zwischen die im Bereich des einen Stegendes Lamellen eingefügt sind, wobei das aus den Stegen und Lamellen bestehende Paket durch Spannmittel zusammengehalten wird.

Der Erfindung liegt die Aufgabe zugrunde, eine thermoelektrische Kühlvorrichtung der eingangs genannten Alt zu schaffen, bei welcher die von dem Peltierblock erzeugte Kälte besonders wirkungsvoll genutzt wird.

Diese Aufgabe wird erfindungsgemäß dadurch gelöst, daß bei einer thermoelektrischen Kühlvorrichtung, insbesondere für Kühlboxen in Kraftfahrzeugen, mit einem aus mindestens einem Peltierblock bestehenden thermoelektrischen Kälteerzeuger, dessen warme Seite mit einem ersten Wärmetauscher wärmeleitend verbunden ist und dessen kalte Seite mit einem dem Kühlen eines Kühlraumes dienenden zweiten Wärmetauscher in wärmeleitender Verbindung steht, wobei der erste Wärmetauscher von einem flüssigen Kühlmittel durchströmt ist, das in einem Flüssigkeitskreislauf zwangsumgewälzt wird, der mit einem dritten Wärmetauscher in Form eines Luft/Flüssigkeits-Wärmetauschers zum Kühlen des flüssigen Kühlmittels versehen ist, der zweite Wärmetauscher als Rippenwärmetauscher zum Kühlen eines durch den Kühlraum hindurchgeleiteten, zwangsumgewälzten Mediums ausgebildet ist und in einem gegenüber dem Kühlraum abgegrenzten Strömungskanal sitzt, dessen vollen Querschnitt der Rippenwärmetauscher einnimmt, wobei der Rippenwärmetauscher aus einem durch Spannmittel zusammengehaltenen Paket von einzelnen Stegen und Lamellen besteht, die im Bereich des einen Stegendes zwischen aufeinanderfolgende Stege eingefügt sind, wobei zwischen die Stege und die Lamellen im Bereich ihrer gegenseitigen Anlageflächen eine Wärmeleitpaste eingebracht ist, wobei mindestens die Stege aus gewalztem Aluminium- oder Kupferblech bestehen und wobei die Stege an den mit dem zwangsumgewälzten Medium in Berührung kommenden Flächen zwecks Erhöhung des Turbulenzgrades des vorbeiströmenden Mediums strukturiert, insbesondere aufgerauht oder verformt, sind.

Bei der thermoelektrischen Kühlvorrichtung nach der Erfindung erfolgt der Wärmeentzug vom Kühlgut durch erzwungene Konvektion. Dadurch bestehen keine Beschränkungen hinsichtlich der Abmessungen und der Form des Kühlgutes. Weil ein Rippenwärmetauscher vorgesehen ist, der den vollen Querschnitt des Strömungskanals für das zwangsumgewälzte Medium einnimmt, wird dem Kühlgut Wärme besonders wirkungsvoll entzogen. Gleichzeitig erfolgt eine effiziente Abführung der Wärme von der warmen Seite des Kälteerzeugers. Dem kommt in Verbindung mit einem Peltierkälteerzeuger besondere Bedeutung zu, weil - im Gegensatz etwa zu einem Kompressionskühlaggregat - praktisch keine räumliche Trennung von Wärmequelle und Wärmesenke besteht. Der Rippenwärmetauscher aus zusammengespannten Stegen und Lamellen hat einen wesentlich höheren Wirkungsgrad als beispielsweise ein aus entsprechendem Werkstoff, z.B. Aluminium, gegossener Wärmetauscher. Die Strukturierung der mit dem zwangsumgewälzten Medium in Berührung kommenden Stegflächen bewirkt eine weitere Verbesserung des Wärmeübergangs.

In weiterer Ausgestaltung der Erfindung liegen zweckmäßig die warme und die kalte Seite des Kälteerzeugers unmittelbar an dem ersten bzw. dem zweiten Wärmetauscher an. Dies erlaubt einen einfachen und raumsparenden Aufbau. Grundsätzlich kann aber beispielsweise auch die warme Seite des Kälteerzeugers mit dem Wärmetauscher über ein Wärmeleitrohr wärmeleitend verbunden sein.

Zweckmäßig sind der Rippenwärmetauscher und/oder der Flüssigkeitswärmetauscher an der mit der kalten bzw. der warmen Seite des Kälteerzeugers in direktem Kontakt stehenden Seite mit einer Beschichtung aus einem Werkstoff mit erhöhter

Wärmeleitfähigkeit, vorzugsweise einer Edelmetallbeschichtung, wie einer galvanisch aufgebrachten, aufgedampften, aufgewalzten oder aufgedruckten Silberschicht versehen. Da in der Regel die Flächenausdehnung des Peltierblockes kleiner sein wird als die dem Peltierblock zugekehrte Seite des Wärmetauschers, sorgt die Beschichtung von erhöhter Wärmeleitfähigkeit für eine wirkungsvolle Verteilung des Wärmestromes auf den Wärmetauscher.

Als leistungsfähiger Flüssigkeitswärmetauscher kann in weiterer Ausgestaltung der Erfindung ein Block aus einem Werkstoff hoher Wärmeleitfähigkeit, z.B. Metall oder einem wärmeleitenden keramischen Werkstoff, vorgesehen sein, der mit einer Mehrzahl von parallelen Durchlässen, z.B. Bohrungen, versehen ist, die unter Bildung eines mäanderförmigen Flüssigkeitskanals an ihrem einen Ende mit dem einen benachbarten Durchlaß und an ihrem anderen Ende mit dem jeweils anderen benachbarten Durchlaß in Strömungsverbindung stehen. Ein verbesserter Wärmeübergang läßt sich dabei erreichen, wenn die Durchlässe in dem Block derart asymmetrisch ausgebildet sind, daß ihr Abstand von der der warmen Seite des Kälteerzeugers zugekehrten Außenfläche kleiner als der Abstand von der dieser Außenfläche gegenüberliegenden Außenfläche des Metallblockes ist. In mindestens einem Teil der Durchlässe kann ein die wirksame Kontaktfläche zwischen dem Kühlmittel und dem Wärmetauscher vergrößerndes Innenprofil vorgesehen sein.

In der Regel wird, wie bereits ausgeführt, die mit der warmen Seite des Kälteerzeugers in Berührung stehende Außenfläche des Metallblockes eine größere Flächenausdehnung als die warme Seite des Kälteerzeugers haben; in einem solchen Fall ist der Kälteerzeuger zweckmäßig auf dieser Außenfläche nahe dem Kühlmitteleinlaß angeordnet, um für eine maximale Temperaturdifferenz zwischen der warmen Seite des Kälteerzeugers und dem den ersten Wärmetauscher durchströmenden flüssigen Kühlmittel zu sorgen.

Die Kühlvorrichtung ist zweckmäßig zusätzlich mit einem Lüfter zum Bereitstellen eines zwangsgeförderten Kühlluftstromes für den Luft/Flüssigkeits-Wärmetauscher versehen. Bei Verwendung der Kühlvorrichtung in einem Kraftfahrzeug kann dieser Lüfter in Abhängigkeit von den jeweils gegebenen Kühlbedingungen, insbesondere in Abhängigkeit von der Fahrzeuggeschwindigkeit, selbsttätig ein- und ausschaltbar sein. Insbesondere kann die Anordnung so getroffen sein, daß der Lüfter nur bei stehendem Fahrzeug arbeitet, während er ausgeschaltet wird, wenn bei fahrendem Fahrzeug der Fahrtwind für eine ausreichende Kühlung des flüssigen Kühlmittels in dem dritten Wärmetauscher sorgt.

Desweiteren ist die Kühlvorrichtung vorteilhaft zusätzlich mit einem für eine Zwangsumwälzung der Kühlrauminnenluft sorgenden Lüfter versehen, der strömungsmäßig in Reihe mit dem Rippenwärmetauscher angeordnet ist und der zweckmäßig über dem Rippenwärmetauscher sitzt, insbesondere in den den Rippenwärmetauscher aufnehmenden Strömungskanal eingebaut ist und mit seiner Einlaßseite mit dem oberen Teil des Kühlraums in freier Verbindung steht.

In weiterer Ausgestaltung der Erfindung wird die thermoelektrische Kühlvorrichtung für eine Kühlbox verwendet, bei welcher der den Rippenwärmetauscher aufnehmende Strömungskanal mit seinem austrittsseitigen unteren Ende an einen Kühlluftverteilerraum im unteren Teil der Kühlbox angeschlossen ist, wobei dieser Kühlluftverteilerraum zweckmäßig mit dem darüberliegenden Kühlraum über einen Lochboden in Strömungsverbindung steht. Dadurch wird die Kaltluft im Kühlraum wirkungsvoll verteilt.

Die Erfindung ist nachstehend anhand eines bevorzugten Ausführungsbeispiels näher erläutert. In den beiliegenden Zeichnungen zeigen:

Fig. 1 eine perspektivische aufgebrochene Darstellung einer insbesondere zur Anwendung in Kraftfahrzeugen bestimmten Kühlbox,

Fig. 2 eine schematische Darstellung einer thermoelektrischen Kühlvorrichtung in Verbindung mit einer Kühlbox gemäß Fig. 1,

Fig. 3 eine auseinandergezogene perspektivische Darstellung des Rippenwärmetauschers sowie des als Flüssigkeitswärmetauscher ausgebildeten ersten Wärmetauschers und eines darauf angeordneten Peltierblockes,

Fig. 4 einen Schnitt durch den Flüssigkeitswärmetauscher gemäß den Linien IV-IV der Fig. 3 und

Fig. 5 einen Schnitt durch den Flüssigkeitswärmetauscher entlang der Linie V-V der Fig. 4.

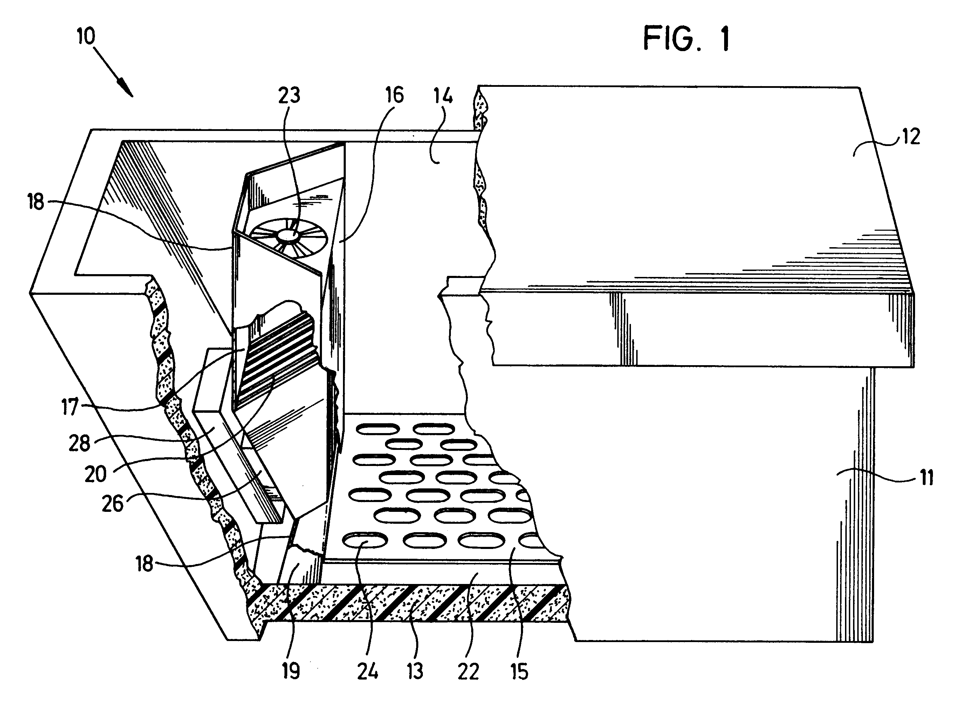

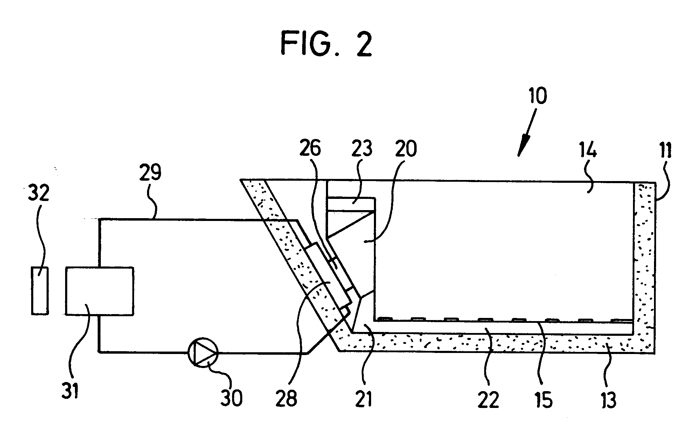

Die Kühlbox 10 gemäß den Fign. 1 und 2 weist ein Unterteil 11 und einen abnehmbaren Deckel 12 auf. Unterteil 11 und Deckel 12 bestehen jeweils aus einem Außenmantel und einem Innenmantel mit dazwischen eingebrachtem Isolationsmaterial 13, beispielsweise Polyurethan-Hartschaumstoff. Die Kühlbox 10 kann hinsichtlich ihrer Innenabmessungen in grundsätzlich beliebiger Weise ausgelegt, beispielsweise zur Aufnahme von etwa fünfzehn handelsüblichen Getränkedosen bestimmt sein. Der nutzbare Kühlraum 14 wird unten von einem Lochbaden 15 und auf der in den Fign. 1 und 2 jeweils linken Seite von einer Wand 16 begrenzt. Die Wand 16 stellt ihrerseits die in den Fign. 1 und 2 rechte Begrenzung eines Strömungskanals 17 dar, der mit hinteren Wandteilen 18 und seitlichen Wandteilen 19 versehen ist. In einem mittleren Abschnitt des Strömungskanals 17 sitzt ein Rippenwärmetauscher 20, der in diesem Bereich den vollen Querschnitt des Strömungskanals 17 einnimmt. Ausgehend vom unteren Ende des Rippenwärmetauschers 20 verbreitert sich der Strömungskanal 17 auf eine Breite, die derjenigen des Lochbodens 15 entspricht.

Das austrittsseitige untere Ende 21 des Strömungskanals 17 steht mit einem unter dem Lochboden 15 liegenden Kühlluftverteilerraum 22 in freier Verbindung. In den Strömungskanal 17 ist oberhalb des Rippenwärmetauschers 20 und strömungsmäßig in Reihe mit letzterem ein Lüfter 23 eingebaut, dessen Einlaßseite mit dem oberen Teil des Kühlraums 14 in freier Verbindung steht. Der Lüfter saugt Luft aus dem Kühlraum 14 an und treibt diese in dem Strömungskanal 17 durch den Rippenwärmetauscher 20 hindurch sowie in den Verteilerraum 22. Von dort gelangt die gekühlte Luft durch beispielsweise langlochförmige Öffnungen 24 des Lochbodens 15 hindurch wieder in den Kühlraum 14.

Der Rippenwärmetauscher 20 hat eine ebene Grundfläche 25, an welcher ein Peltierblock 26 mit seiner kalten Seite 45 anliegt. Die der Seite 45 gegenüberliegende warme Seite des Peltierblocks 26 steht in flächigem wärmeleitendem Kontakt mit der dem Wärmetauscher 20 zugewendeten Seite 27 eines Flüssigkeitswärmetauschers 28. Der Flüssigkeitswärmetauscher 28 sorgt für eine Abführung der an der warmen Seite des Peltierblockes 26 erzeugten Wärme über flüssiges Kühlmittel, das in einem Flüssigkeitskreislauf 29 (Fig. 2) umgewälzt wird. In dem Flüssigkeitskreislauf 29 liegen ferner eine Umwälzpumpe 30 und ein Luft/Flüssigkeits-Wärmetauscher 31. Als flüssiges Kühlmittel eignet sich insbesondere Wasser oder ein Gemisch von Wasser und Frostschutzmittel. Dem Wärmetauscher 31 ist ein Lüfter 32 zugeordnet, der einen zwangsgeförderten Kühlluftstrom bereitstellt und der in nicht näher veranschaulichter Weise in Abhängigkeit von den jeweils gegebenen Kühlbedingungen, beispielsweise in Abhängigkeit von der Fahrzeuggeschwindigkeit, selbsttätig ein- und ausgeschaltet wird.

Der Peltierblock 26, die Lüfter 23 und 32 sowie die Umwälzpumpe 30 werden aus dem Bordnetz mit Gleichstrom gespeist.

Bei der veranschaulichten Ausführungsform ist als Kälteerzeuger ein einzelner Peltierblock 26 vorgesehen. Es versteht sich jedoch, daß auch mehrere solche Blöcke parallel und/oder hintereinander angeordnet werden können. Wird im letztgenannten Falle die warme Seite des an den Rippenwärmetauscher 20 angrenzenden Peltierblockes mit einem zweiten Peltierblock gekühlt, ist zu beachten, daß letzterer eine größere Leistung besitzen muß als der erste.

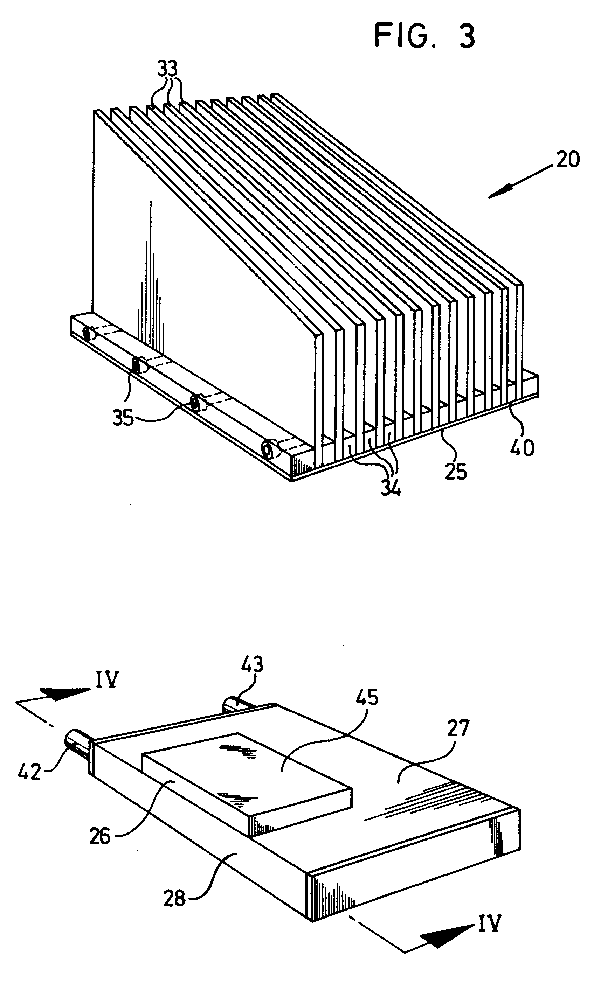

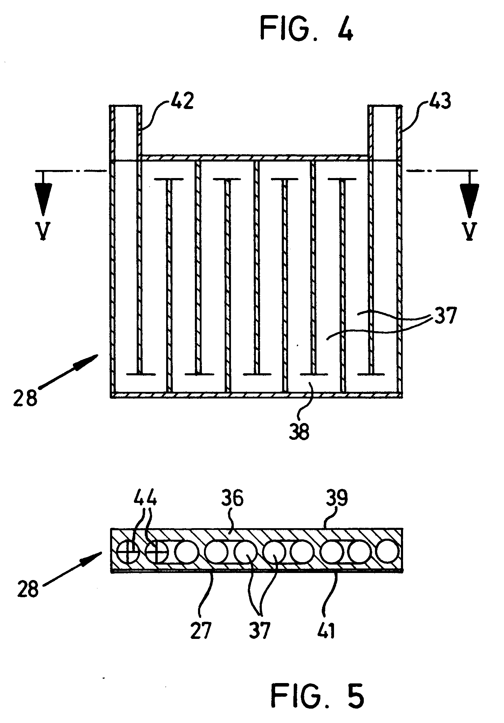

Durch die erläuterte Verwendung einer Wärmeübertragung durch erzwungene Konvektion über den Rippenwärmetauscher 20 kann auch größeres Kühlgut wirkungsvoll gekühlt werden, obwohl die Fläche der kalten Seite 45 des Peltierblockes 26 geringe Abmessungen hat, beispielsweise nur 40 x 40 mm groß ist. Dabei wird die Luft in der Kühlbox 10 als Übertragungsmedium für die Kälteleistung genutzt. Um die Wärme von den relativ kleinen Oberflächen des Peltierblockes 26 auf die im Vergleich dazu größeren Oberflächen der an dem Peltierblock anliegenden Seiten der Wärmetauscher 20 und 27 besonders wirkungsvoll zu verteilen, sind diese Seiten 25, 27 vorzugsweise mit einer in den Fign. 3 und 5 bei 40 bzw. 41 angedeuteten Beschichtung aus einem Werkstoff versehen, der höhere Wärmeleitfähigkeit als der Werkstoff des betreffenden Wärmetauschers hat. Dazu eignet sich insbesondere eine Silberschicht, die auf den Wärmetauscher 20 bzw. 28 galvanisch aufgebracht, aufgewalzt, aufgedampft oder aufgedruckt sein kann.

Der Rippenwärmetauscher 20 ist, wie im einzelnen in Fig. 3 veranschaulicht ist, aus einer Mehrzahl von einzelnen Stegen 33 und einer Mehrzahl von Lamellen 34 zusammengesetzt. Die streifenförmigen Lamellen 34 sind im Bereich des einen (in Fig. 3 unteren) Stegendes zwischen aufeinanderfolgende Stege eingefügt. Das Verhältnis zwischen der Breite der Lücken zwischen den Stegen und der Stegbreite liegt zweckmäßig im Bereich von etwa 2:1 bis 4:1. Das so entstehende Paket aus Stegen 33 und Lamellen 34 ist mittels Spannschrauben 35 zusammengehalten, die sich durch das Paket quer hindurcherstrecken. Mindestens die Stege und vorzugsweise auch die Lamellen bestehen aus gut wärmeleitendem, gewalztem Aluminium- oder Kupferblech. Im Bereich ihrer gegenseitigen Anlageflächen sind die Stege und Lamellen 33, 34 mit einer Wärmeleitpaste versehen sein. Zur weiteren Verbesserung des Wärmeübergangs sind die Stege 33 aufgerauht oder in anderer Weise strukturiert oder verformt, wodurch der Turbulenzgrad des vorbeiströmenden Mediums erhöht wird.

Der Flüssigkeitswärmetauscher 28 besteht bei der veranschaulichten bevorzugten Ausführungsform aus einem Block 36 hoher Wärmeleitfähigkeit. Der beispielsweise metallische Block ist mit einer Mehrzahl von parallelen Bohrungen 37 versehen, die in dem Block 36 einen mäanderförmigen Flüssigkeitskanal 38 zwischen einem Kühlmitteleinlaß 42 und einem Kühlmittelauslaß 43 entstehen lassen, indem jede der Bohrungen 37 - mit Ausnahme der beiden äußeren Bohrungen - an ihrem einen Ende mit der einen benachbarten Bohrung und an ihrem anderen Ende mit der jeweils anderen benachbarten Bohrung in Strömungsverbindung steht. Die Bohrungen 37 liegen, wie aus Fig. 5 hervorgeht, der an dem Peltierblock 26 anliegenden Außenfläche 27 näher als der gegenüberliegenden Außenfläche 39, um den Wärmewiderstand zwischen Peltierblock 26 und dem den Flüssigkeitskanal 38 durchströmenden flüssigen Kühlmittel zu minimieren. An Stelle der mit rundem Querschnitt versehenen Bohrungen 37 können auch Durchlässe anderer Querschnittsform, beispielsweise Durchlässe mit rechteckigem Querschnitt, vorgesehen sein. Im letztgenannten Falle ist die Kühlflüssigkeit im Mittel näher an der warmen Peltierblockseite als bei runden Durchlässen. Zur Vergrößerung der wirksamen Kontaktfläche können die Durchlässe, beispielsweise die Bohrungen 37, mit Innenprofilen versehen sein, z.B. mit kreuzförmigen Innenprofilteilen 44, wie sie in Fig. 5 bei den beiden äußeren linken Bohrungen 37 angedeutet sind.

Im Rahmen der Erfindung sind zahlreiche Abwandlungen möglich. Beispielsweise kann der Flüssigkeitswärmetauscher 28, der in den Fign. 1 und 2 innerhalb der Kühlbox 10 dargestellt ist, auch auf die Aussenseite dieser Box verlegt werden. Statt den Wärmetauscher 28 unmittelbar an der warmen Seite des Peltierblockes anliegen zu lassen, können Wärmetauscher 28 und Peltierblock 26 auch über ein Wärmeleitrohr wärmeleitend untereinander verbunden sein.

Die Erfindung ist auch nicht auf die Anwendung bei einer Kühlbox beschränkt. Beispielsweise eignet sich die erläuterte Kühlvorrichtung grundsätzlich auch für Kühlanwendungen beliebiger anderer Art, beispielsweise zum Kühlen von elektronischen Geräten, wie Rechnern und dergleichen. Auf entsprechende Weise kann auch eine Klimaanlage aufgebaut werden. Beispielsweise kann in einem Bus jedem Sitzplatz ein Peltier-Kälteerzeuger zugeordnet werden, und der Lüfter 23 kann jedem Sitzplatz in getrennt regelbarer Weise Kaltluft zuführen, während die einzelnen Flüssigkeitswärmetauscher 28 an einen gemeinsamen Flüssigkeitskreislauf entsprechend dem Kreislauf 29 angeschlossen sein können. Insbesondere bei stationärem Einsatz kann die Kühlvorrichtung gegebenenfalls auch aus Solarzellen gespeist werden. Die den Flüssigkeitskreislauf 29 durchströmende Flüssigkeit kann gegebenenfalls auch für Wärmezwecke genutzt werden, beispielsweise um in einer Busbordküche mindestens einen Teil der Wärme bereitzustellen, die zum Erwärmen von Nahrungsmitteln oder Getränken benötigt wird. Insbesondere bei Verwendung von hintereinandergesetzten Peltierblöcken ist auch die Erzeugung von Eiswürfeln möglich.

Entsprechend einer weiteren Abwandlung kann an Stelle des beschriebenen Luftzwangsumlaufs auch ein Flüssigkeitskreislauf vorgesehen werden, wobei zu kühlendes Gut in die mittels des Peltier-Kälteerzeugers gekühlte Flüssigkeit eingestellt werden kann. Bei der gekühlten Flüssigkeit kann es sich aber auch beispielsweise um Schmieröl in einem Schmierölkreislauf in Fahrzeugen oder Maschinen handeln.

**Patentansprüche**

1. Thermoelektrische Kühlvorrichtung, insbesondere für Kühlboxen in Kraftfahrzeugen, mit einem aus mindestens einem Peltierblock (26) bestehenden thermoelektrischen Kälteerzeuger, dessen warme Seite mit einem ersten Wärmetauscher (28) wärmeleitend verbunden ist und dessen kalte Seite mit einem dem Kühlen eines Kühlraumes (14) dienenden zweiten Wärmetauscher (20) in wärmeleitender Verbindung steht, wobei der erste Wärmetauscher (28) von einem flüssigen Kühlmittel durchströmt ist, das in einem Flüssigkeitskreislauf (29) zwangsumgewälzt wird, der mit einem dritten Wärmetauscher in Form eines Luft/Flüssigkeits-Wärmetauschers (31) zum Kühlen des flüssigen Kühlmittels versehen ist, dadurch gekennzeichnet, daß der zweite Wärmetauscher als Rippenwärmetauscher (20) zum Kühlen eines durch den Kühlraum (14) hindurchgeleiteten, zwangsumgewälzten Mediums ausgebildet ist und in einem gegenüber dem Kühlraum abgegrenzten Strömungskanal (17) sitzt, dessen vollen Querschnitt der Rippenwärmetauscher (20) einnimmt, wobei der Rippenwärmetauscher (20) aus einem durch Spannmittel (35) zusammengehaltenen Paket von einzelnen Stegen (33) und Lamellen (34) besteht, die im Bereich des einen Stegendes zwischen aufeinanderfolgende Stege eingefügt sind, wobei zwischen die Stege (33) und die Lamellen (34) im Bereich ihrer gegenseitigen Anlageflächen eine Wärmeleitpaste eingebracht ist, wobei mindestens die Stege (33) aus gewalztem Aluminium- oder Kupferblech bestehen und wobei die Stege (33) an den mit dem zwangsumgewälzten Medium in Berührung kommenden Flächen zwecks Erhöhung des Turbulenzgrades des vorbeiströmenden Mediums strukturiert, insbesondere aufgerauht oder verformt, sind.

2. Thermoelektrische Kühlvorrichtung nach Anspruch 1, dadurch gekennzeichnet, daß die warme und die kalte Seite des Kälteerzeugers (26) unmittelbar an dem ersten bzw. dem zweiten Wärmetauscher (28, 20) anliegen.

3. Thermoelektrische Kühlvorrichtung nach Anspruch 1, dadurch gekennzeichnet, daß die warme Seite des Kälteerzeugers (26) mit dem ersten Wärmetauscher (28) über ein Wärmeleitrohr wärmeleitend verbunden ist.

4. Thermoelektrische Kühlvorrichtung nach einem der vorhergehenden Ansprüche, dadurch gekennzeichnet, daß der Rippenwärmetauscher (20) und/oder der Flüssigkeitswärmetauscher (28) mit einer Beschichtung (40, 41) aus einem Werkstoff mit erhöhter Wärmeleitfähigkeit versehen ist.

5. Thermoelektrische Kühlvorrichtung nach Anspruch 4, dadurch gekennzeichnet, daß als Beschichtung eine Silberschicht galvanisch aufgebracht, aufgedampft, aufgewalzt oder aufgedruckt ist.

6. Thermoelektrische Kühlvorrichtung nach einem der vorhergehenden Ansprüche, dadurch gekennzeichnet, daß als Spannmittel für den Rippenwärmetauscher (20) Spannschrauben (35) vorgesehen sind, die sich durch das Paket aus Stegen (33) und Lamellen (34) quer hindurcherstrecken.

7. Thermoelektrische Kühlvorrichtung nach einem der vorhergehenden Ansprüche, dadurch gekennzeichnet, daß der Flüssigkeitswärmetauscher (28) einen Block (36) aus einem Werkstoff hoher Wärmeleitfähigkeit aufweist, der mit einer Mehrzahl von parallelen Durchlässen (37) versehen ist, die unter Bildung eines mäanderförmigen Flüssigkeitskanals (38) an ihrem einen Ende mit dem einen benachbarten Durchlaß und an ihrem anderen Ende mit dem jeweils anderen benachbarten Durchlaß in Strömungsverbindung stehen.

8. Thermoelektrische Kühlvorrichtung nach Anspruch 7, dadurch gekennzeichnet, daß die Durchlässe (37) in dem Block (36) derart asymmetrisch ausgebildet sind, daß ihr Abstand von der der warmen Seite des Kälteerzeugers (26) zugekehrten Außenfläche (27) kleiner als der Abstand von der dieser Außenfläche gegenüberliegenden Außenfläche (39) des Blockes ist.

9. Thermoelektrische Kühlvorrichtung nach Anspruch 7 oder 8, dadurch gekennzeichnet, daß in mindestens einem Teil der Durchlässe (37) ein die wirksame Kontaktfläche vergrößerndes Innenprofil (44) vorgesehen ist.

10. Thermoelektrische Kühlvorrichtung nach Anspruch 2 und einem der Ansprüche 7 bis 9, dadurch gekennzeichnet, daß die mit der warmen Seite des Kälteerzeugers (26) in Berührung stehende Außenfläche (27) des Blockes (36) eine größere Flächenausdehnung als die warme Seite des Kälteerzeugers hat und daß der Kälteerzeuger auf dieser Außenfläche nahe dem Kühlmitteleinlaß (42) angeordnet ist.

11. Thermoelektrische Kühlvorrichtung nach einem der vorhergehenden Ansprüche, dadurch gekennzeichnet, daß die Kühlvorrichtung zusätzlich mit einem Lüfter (32) zum Bereitstellen eines zwangsgeförderten Kühlluftstromes für den Luft/Flüssigkeitswärmetauscher (31) versehen ist.

12. Thermoelektrische Kühlvorrichtung nach Anspruch 11 zur Verwendung in Kraftfahrzeugen, dadurch gekennzeichnet, daß der Lüfter (32) in Abhängigkeit von den jeweils gegebenen Kühlbedingungen, insbesondere in Abhängigkeit von der Fahrzeuggeschwindigkeit, selbsttätig ein- und ausschaltbar ist.

13. Thermoelektrische Kühlvorrichtung nach einem der vorhergehenden Ansprüche, dadurch gekennzeichnet, daß die Kühlvorrichtung zusätzlich mit einem für eine Zwangsumwälzung der Kühlrauminnenluft sorgenden Lüfter (23) versehen ist, der strömungsmäßig in Reihe mit dem Rippenwärmetauscher (20) angeordnet ist.

14. Thermoelektrische Kühlvorrichtung nach Anspruch 13, dadurch gekennzeichnet, daß der Lüfter (23) über dem Rippenwärmetauscher (20) sitzt und die Einlaßseite des Lüfters (23) mit dem oberen Teil des Kühlraums (14) in freier Strömungsverbindung steht.

15. Thermoelektrische Kühlvorrichtung nach Anspruch 13 oder 14, dadurch gekennzeichnet, daß der Lüfter (23) in den den Rippenwärmetauscher (30) aufnehmenden Strömungskanal (17) eingebaut ist.

16. Verwendung der thermoelektrischen Kühlvorrichtung nach einem der vorhergehenden Ansprüche für eine Kühlbox (10), bei welcher der den Rippenwärmetauscher (20) aufnehmende Strömungskanal (17) mit seinem austrittsseitigen unteren Ende (21) an einen Kühlluftverteilerraum (22) im unteren Teil der Kühlbox (10) angeschlossen ist.

17. Verwendung nach Anspruch 16 bei einer Kühlbox (10), bei welcher der Kühlluftverteilerraum (22) mit dem darüberliegenden Kühlraum (14) über einen Lochboden (15) in Strömungsverbindung steht.

**Claims**

1. Thermoelectric cooling device, in particular for cold storage boxes in motor vehicles, with a thermoelectric refrigerator consisting of at least one Peltier block (26), whose warm side is thermally conductively connected to a first heat exchanger (28) and whose cold side communicates thermally conductively with a second heat exchanger (20) for cooling a refrigerator chamber (14), wherein a liquid coolant passes through the first heat exchanger (28) and is forcibly circulated in a liquid circuit (29), which is provided with a third heat exchanger in the form of an air/liquid heat exchanger (31) for cooling the liquid coolant, characterised in that the second heat exchanger is formed as a ribbed heat exchanger (20) for cooling a forcibly circulated medium passing through the refrigerator chamber (14) and rests in a flow channel (17), which is separated from the refrigerator chamber and whose full cross-section includes the ribbed heat exchanger (20), wherein the ribbed heat exchanger (20) consists of a bundle of individual webs (33) and plates (34), which are held together by clamping means (35), the plates (34) being inserted in the region of one web end between consecutive webs, wherein a heat-conducting paste is inserted between the webs (33) and the plates (34) in the region of their mutual contact faces, wherein at least the webs (33) consist of rolled aluminium or copper plate, and wherein the webs (33) are structured, in particular roughened or deformed, on the faces coming into contact with the forcibly circulated medium, in order to increase the degree of turbulence of the passing medium.

2. Thermoelectric cooling device according to claim 1, characterised in that the warm and the cold side of the refrigerator (26) directly abut the first or second heat exchanger (28, 30) respectively.

3. Thermoelectric cooling device according to claim 1, characterised in that the warm side of the refrigerator (26) is thermally conductively connected to the first heat exchanger (28) via a heat conducting tube.

4. Thermoelectric cooling device according to one of the preceding claims, characterised in that the ribbed heat exchanger (20) and/or the liquid heat exchanger (28) is provided with a coating (40, 41) of a material with increased heat conductivity.

5. Thermoelectric cooling device according to claim 4, characterised in that, as a coating, a layer of silver is applied galvanically, steamed on, rolled on or printed on.

6. Thermoelectric cooling device according to one of the preceding claims, characterised in that as clamping means for the ribbed heat exchanger (20) clamping screws (35) are provided, which extend transversely through the bundle of webs (33) and plates (34).

7. Thermoelectric cooling device according to one of the preceding claims, characterised in that the liquid heat exchanger (28) has a block (36) of a highly heat-conductive material, which is provided with a plurality of parallel passages (37), which have a flow connection at one end with one of the adjacent passages and at their other end with the respectively other adjacent passage, so as to form a meandering liquid channel (38).

8. Thermoelectric cooling device according to claim 7, characterised in that the passages (37) in the block (36) are asymmetrically formed, so that their distance from the outer face (27) facing the warm side of the refrigerator (26) is smaller than the distance from the outer face (39) of the block opposite this outer face.

9. Thermoelectric cooling device according to claim 7 or 8, characterised in that an inner profile (44) which increases the active contact face is provided in at least some of the passages (37).

10. Thermoelectric cooling device according to claim 2 and one of claims 7 to 9, characterised in that the outer face (27) of the block (36) in contact with the warm side of the refrigerator (26) has a larger surface extent than the warm side of the refrigerator, and in that the refrigerator is mounted on this outer face close to the coolant inlet (42).

11. Thermoelectric cooling device according to one of the preceding claims, characterised in that the cooling device is additionally provided with a fan (32) for providing a forcibly conveyed cool air flow for the air/liquid heat exchanger (31).

12. Thermoelectric cooling device according to claim 11 for use in motor vehicles, characterised in that the fan (32) switches on and off automatically as a function of the respectively prevailing cooling conditions, in particular as a function of the vehicle speed.

13. Thermoelectric cooling device according to one of the preceding claims, characterised in that the cooling device is additionally provided with a fan (23) for ensuring forcible circulation of the air inside the refrigerator chamber, the fan (23) being mounted flow-wise in alignment with the ribbed heat exchanger (20).

14. Thermoelectric cooling device according to claim 13, characterised in that the fan (23) rests over the ribbed heat exchanger (20) and the inlet side of the fan (23) communicates with the upper part of the refrigerator chamber (14) in free flow connection.

15. Thermoelectric cooling device according to claim 13 or 14, characterised in that the fan (23) is fitted in the flow channel (17) which receives the ribbed heat exchanger (30).

16. Use of the thermoelectric cooling device according to one of the preceding claims for a cold storage box (10), in which the flow channel (17) receiving the ribbed heat exchanger (20) is connected by its outlet-side lower end (21) to a cooling air distribution chamber (22) in the lower part of the cold storage box (10).

17. Use according to claim 16 in a cold storage box (10) in which the cooling air distribution chamber (22) is in flow connection with the refrigerator chamber (14) above via a perforated base (15).

**Revendications**

1. Dispositif réfrigérant thermoélectrique, en particulier pour caisses frigorifiques à bord de véhicules automobiles, comprenant un générateur thermoélectrique de froid se composant d'au moins un bloc de Peltier (26) et dont le côté chaud est en liaison de conduction thermique avec un premier échangeur de chaleur (28) tandis que son côté froid est en liaison de conduction thermique avec un deuxième échangeur de chaleur (20) destiné à refroidir une enceinte frigorifique (14), le premier échangeur de chaleur (28) étant balayé par un agent réfrigérant liquide subissant une circulation forcée en un circuit fermé (29) qui comprend un troisième échangeur de chaleur sous forme d'un échangeur de chaleur (31) air/liquide destiné à refroidir l'agent réfrigérant liquide, caractérisé en ce que le deuxième échangeur de chaleur est conformé en échangeur de chaleur à ailettes (20) qui est destiné à refroidir un fluide en circulation forcée passant par l'enceinte frigorifique (14) et qui est logé dans un canal de circulation (17) qui est séparé de l'enceinte frigorifique par une cloison et dont l'échangeur de chaleur à ailettes (20) occupe la totalité de la section, l'échangeur de chaleur à ailettes (20) se composant d'un groupe de plaquettes individuelles (33) et de lamelles (34) assemblées au moyen d'organes de serrage (35), lesdites lamelles étant insérées entre les plaquettes successives, au voisinage de l'une des extrémités de ces dernières, une pâte thermoconductrice étant placée sur les surfaces d'appui mutuel entre les plaquettes (33) et les lamelles (34), au moins les plaquettes (33) étant constituées de tôle laminée d'aluminium ou de cuivre et les surfaces des plaquettes (33) entrant en contact avec le fluide en circulation forcée étant structurées, en particulier rendues rugueuses ou déformées, afin d'accroître le taux de turbulence du fluide qui les balaie.

2. Dispositif réfrigérant thermoélectrique selon la revendication 1, caractérisé en ce que le côté chaud et le côté froid du générateur de froid (26) sont appliqués directement contre le premier et respectivement contre le deuxième échangeur de chaleur (28, 20).

3. Dispositif réfrigérant thermoélectrique selon la revendication 1, caractérisé en ce que le côté chaud du générateur de froid (26) est en liaison de conduction thermique avec le premier échangeur de chaleur (28) au moyen d'un tube thermoconducteur.

4. Dispositif réfrigérant thermoélectrique selon l'une des revendications précédentes, caractérisé en ce que l'échangeur de chaleur à ailettes (20) et/ou l'échangeur de chaleur à liquide (28) comporte un revêtement (40, 41) d'un matériau à conductibilité thermique élevée.

5. Dispositif réfrigérant thermoélectrique selon la revendication 4, caractérisé en ce que le revêtement est une couche d'argent déposée galvaniquement, en phase vapeur, par laminage ou par impression.

6. Dispositif réfrigérant thermoélectrique selon l'une des revendications précédentes, caractérisé en ce que les organes de serrage prévus pour l'échangeur de chaleur à ailettes (20) sont des boulons (35) qui traversent le groupe des plaquettes (33) et des lamelles (34).

7. Dispositif réfrigérant thermoélectrique selon l'une des revendications précédentes, caractérisé en ce que l'échangeur de chaleur à liquide (28) comprend un bloc (36) en un matériau à conductibilité thermique élevée qui comporte de multiples passages parallèles (37) qui forment un canal en créneaux (38) pour le liquide et dont une extrémité raccorde la circulation à l'un des passages voisins tandis que son autre extrémité raccorde la circulation à l'autre passage voisin correspondant.

8. Dispositif réfrigérant thermoélectrique selon la revendication 7, caractérisé en ce que les passages (37) sont réalisés asymétriquement dans le bloc (36) de manière que leur distance à la surface extérieure (27) tournée vers le côté chaud du générateur de froid (26) soit plus petite que la distance à la surface extérieure (39) du bloc qui est tournée à l'opposé de cette surface extérieure.

9. Dispositif réfrigérant thermoélectrique selon la revendication 7 ou 8, caractérisé en ce qu'un profilage intérieur (44) accroissant la surface efficace de contact est prévu dans au moins une partie des passages (37).

10. Dispositif réfrigérant thermoélectrique selon la revendication 2 et l'une des revendications 7 à 9, caractérisé en ce que la surface extérieure (27) du bloc (36) qui est en contact avec le côté chaud du générateur de froid (26) a une superficie supérieure à celle du côté chaud du générateur de froid et en ce que le générateur de froid est disposé sur cette surface extérieure à proximité de l'entrée (42) de l'agent réfrigérant.

11. Dispositif réfrigérant thermoélectrique selon l'une des revendications précédentes, caractérisé en ce que le dispositif réfrigérant est équipé accessoirement d'un ventilateur (32) destiné à produire un courant d'air froid en circulation forcée pour l'échangeur de chaleur air/liquide (31).

12. Dispositif réfrigérant thermoélectrique selon la revendication 11, destiné à être utilisé dans des véhicules automobiles, caractérisé en ce que le ventilateur (32) est enclenchable et déclenchable automatiquement en fonction des conditions régnantes particulières de refroidissement, en particulier en fonction de la vitesse du véhicule.

13. Dispositif réfrigérant thermoélectrique selon l'une des revendications précédentes, caractérisé en ce que le dispositif réfrigérant est équipé accessoirement d'un ventilateur (23) assurant une circulation forcée en circuit fermé de l'air situé à l'intérieur de l'enceinte frigorifique, ce ventilateur étant monté dans le circuit en série avec l'échangeur de chaleur à ailettes (20).

14. Dispositif réfrigérant thermoélectrique selon la revendication 13, caractérisé en ce que le ventilateur (23) est placé sur l'échangeur de chaleur à ailettes (20) et le côté admission du ventilateur (23) communique avec la partie supérieure de l'enceinte frigorifique (14) de manière à permettre une libre circulation.

15. Dispositif réfrigérant thermoélectrique selon la revendication 13 ou 14, caractérisé en ce que le ventilateur (23) est monté dans le canal de circulation (17) qui loge l'échangeur de chaleur à ailettes (20).

16. Utilisation du dispositif réfrigérant thermoélectrique selon l'une des revendications précédentes pour une caisse frigorifique (10) dans laquelle l'extrémité inférieure (21), côté sortie, du canal de circulation (17) logeant l'échangeur de chaleur à ailettes (20) est raccordée à une chambre de distribution d'air froid (22) située dans la partie inférieure de la caisse frigorifique (10).

17. Utilisation selon la revendication 16 pour une caisse frigorifique (10) dans laquelle un fond perforé (15) permet la circulation entre la chambre de distribution d'air froid (22) et l'enceinte frigorifique (14) située au-dessus de cette dernière.

FIG. 1

EP 0 271 704 B1

# FIG. 2

FIG. 3

FIG. 4

FIG. 5